# EUROPÄISCHE PATENTANMELDUNG

(11) **EP 4 060 098 A1**
(43) Veröffentlichungstag der Anmeldung: **21.09.2022**
(21) Anmeldenummer: 21163801.0
(22) Anmeldetag: 19.03.2021
(51) Int. Cl.: C30B 23/02, C30B 29/36

(54) **HERSTELLUNGSVERFAHREN FÜR EINEN SIC-VOLUMENEINKRISTALL INHOMOGENER SCHRAUBENVERSETZUNGSVERTEILUNG UND SIC-SUBSTRAT**

(71) Anmelder: SiCrystal GmbH, 90411 Nürnberg (DE)
(72) Erfinder: Ecker, Bernhard, 90491 Nürnberg (DE); Müller, Ralf, 90513 Zirndorf (DE); Stockmeier, Matthias, 91349 Egloffstein (DE); Vogel, Michael, 90489 Nürnberg (DE); Weber, Arnd-Dietrich, 91301 Forchheim (DE)
(74) Vertreter: Rau, Schneck & Hübner Patentanwälte Rechtsanwälte PartGmbB

(57) **Zusammenfassung**

Das Verfahren ist zur Herstellung mindestens eines SiC-Volumeneinkristalls (2) mittels einer Sublimationszüchtung bestimmt, wobei vor Züchtungsbeginn in einem Kristallwachstumsbereich eines Züchtungstiegels ein SiC-Keimkristall (8) mit einer Wachstumsoberfläche angeordnet wird und in einen SiC-Vorratsbereich des Züchtungstiegels SiC-Quellmaterial eingebracht wird. Während der Züchtung wird bei einer Züchtungstemperatur von bis zu 2400°C und einem Züchtungsdruck zwischen 0,1 mbar und 100 mbar mittels Sublimation des SiC-Quellmaterials und mittels Transport der sublimierten gasförmigen Komponenten in den Kristallwachstumsbereich dort eine SiC-Wachstumsgasphase erzeugt, in der mittels Abscheidung aus der SiC-Wachstumsgasphase auf dem SiC-Keimkristall ein SiC-Volumeneinkristall (2) aufwächst. In den SiC-Keimkristall (8) wird vor Züchtungsbeginn bei Raumtemperatur eine mechanische Spannung eingebracht, um im SiC-Keimkristall (8) vorhandene Keim-Schraubenversetzungen (24) unter dem Einfluss der mechanischen Spannung zu einer Versetzungsbewegung zu veranlassen, so dass Keim-Schraubenversetzungen (24), die sich im Zusammenhang mit ihrer jeweiligen Versetzungsbewegung einander annähern, miteinander rekombinieren und sich gegenseitig auslöschen.

## Beschreibung

Die Erfindung betrifft ein Verfahren zur Herstellung mindestens eines SiC-Volumeneinkristalls mittels einer Sublimationszüchtung sowie ein einkristallines SiC-Substrat.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt.

Basis für die SiC-Substrate sind hochwertige SiC-Volumeneinkristalle, die in der Regel mittels physikalischer Gasphasenabscheidung (PVT) hergestellt werden, insbesondere mittels eines z.B. in der US 8,865,324 B2 beschriebenen (Sublimations-)Verfahrens. Bei diesem Züchtungsverfahren wird eine einkristalline SiC-Scheibe als SiC-Keimkristall zusammen mit geeignetem Quellmaterial in einen Züchtungstiegel eingebracht. Unter kontrollierten Temperatur- und Druckbedingungen wird das Quellmaterial sublimiert und die gasförmigen Spezies scheiden sich auf dem SiC-Keimkristall ab, so dass der SiC-Volumeneinkristall dort aufwächst.

Aus dem SiC-Volumeneinkristall werden anschließend z.B. mit Hilfe einer Fadensäge scheibenförmige einkristalline SiC-Substrate herausgeschnitten, die nach einer mehrstufigen veredelnden Bearbeitung ihrer Oberfläche, insbesondere mittels mehrerer Polierschritte, im Rahmen der Bauelementefertigung mit mindestens einer dünnen einkristallinen Epitaxieschicht z.B. aus SiC oder GaN (Galliumnitrid) versehen werden. Die Eigenschaften dieser Epitaxieschicht und damit letztlich auch die der daraus hergestellten Bauelemente hängen entscheidend von der Qualität des SiC-Substrats bzw. des zugrundeliegenden SiC-Volumeneinkristalls ab.

Für die Herstellung der epitaktischen Schichten sind unter anderem auch im SiC-Substrat gegebenenfalls vorhandene Schraubenversetzungen (engl.: "threading screw dislocation", abgekürzt als TSD) von Bedeutung, da sich die Schraubenversetzungen in die epitaktische Schicht fortpflanzen können, was eine reduzierte Qualität und/oder Ausbeute der daraus gefertigten elektronischen Bauelemente zur Folge haben kann. Für eine hohe Ausbeute sollten Kristalldefekte, wie z.B. Schraubenversetzungen, die während des Kristallwachstums durch Abweichungen von der idealen Kristallform entstehen können, weitestgehend vermieden werden. Weiterhin ist die Herstellung von SiC-Volumeneinkristallen durch den PVT-Prozess sehr kosten- und zeitintensiv. Material, das z.B. durch eine versetzungsbedingte unvollkommene Kristallstruktur für die Weiterverwendung zur Bauelementeherstellung unbrauchbar ist, führt deshalb zu stark verringerten Ausbeuten und erhöhten Kosten.

In der US 9,234,297 B2 wird ein Verfahren beschrieben, welches auf einem zweistufigen Züchtungsprozess basiert, wobei in einer ersten Züchtungsstufe bei niedriger Wachstumsgeschwindigkeit und erhöhtem Druck Schraubenversetzungen im Randbereich des aufwachsenden SiC-Volumeneinkristalls in Stapelfehler umgewandelt werden, die dann senkrecht zur Wachstumsrichtung nach außen wachsen. In der sich anschließenden zweiten Züchtungsstufe wird die Wachstumsgeschwindigkeit (bei abgesenktem Druck) erhöht und der ab dann aufwachsende SiC-Volumeneinkristall hat im Randbereich ein Kristallvolumen mit einer reduzierten Anzahl von Schraubenversetzungen. Allerdings genügt die erreichte Reduzierung der Schraubenversetzungsdichte nicht aus, um elektronische Bauelemente auf SiC-Substraten wirtschaftlich herstellen zu können. Daher ist weitere Reduzierung wünschenswert.

Die Aufgabe der Erfindung besteht darin, ein gegenüber den bekannten Lösungen verbessertes Verfahren zur Herstellung eines SiC-Volumeneinkristalls sowie ein verbessertes einkristallines SiC-Substrat anzugeben.

Zur Lösung der das Verfahren betreffenden Aufgabe wird ein Verfahren entsprechend den Merkmalen des Patentanspruchs 1 angegeben. Bei dem erfindungsgemäßen Verfahren handelt es sich um ein solches zur Herstellung mindestens eines SiC-Volumeneinkristalls mittels einer Sublimationszüchtung, wobei vor Züchtungsbeginn in einem Kristallwachstumsbereich eines Züchtungstiegels ein SiC-Keimkristall mit einer Wachstumsoberfläche angeordnet wird und in einen SiC-Vorratsbereich des Züchtungstiegels SiC-Quellmaterial, insbesondere pulverförmiges oder insbesondere verdichtetes, bevorzugt zumindest teilweise verdichtetes SiC-Quellmaterial oder insbesondere SiC-Quellmaterial in Form eines einkristallinen oder polykristallinen Festkörperblocks, bevorzugt mit einer Dichte von 3,0 g/cm² bis 3,21 g/cm², oder insbesondere eine Kombination aus diesen verschiedenen SiC-Quellmaterialien, eingebracht wird. Während der Züchtung wird bei einer, insbesondere an einer Wachstumsgrenzfläche des aufwachsenden SiC-Volumeneinkristalls herrschenden, Züchtungstemperatur von bis zu 2400°C und einem Züchtungsdruck zwischen 0,1 mbar und 100 mbar mittels Sublimation des SiC-Quellmaterials und mittels Transport der sublimierten gasförmigen Komponenten in den Kristallwachstumsbereich dort eine SiC-Wachstumsgasphase erzeugt, in der mittels Abscheidung aus der SiC-Wachstumsgasphase auf dem SiC-Keimkristall ein SiC-Volumeneinkristall aufwächst. In den SiC-Keimkristall wird vor Züchtungsbeginn bei Raumtemperatur eine mechanische Spannung eingebracht, um im SiC-Keimkristall vorhandene Keim-Schraubenversetzungen unter dem Einfluss der mechanischen Spannung zu einer Versetzungsbewegung zu veranlassen, so dass Keim-Schraubenversetzungen, die sich im Zusammenhang mit ihrer jeweiligen Versetzungsbewegung einander annähern, miteinander rekombinieren und sich gegenseitig auslöschen.

Die Versetzungsbewegung und die Rekombination der Keim-Schraubenversetzungen erfolgen vorzugsweise innerhalb des SiC-Keimkristalls. Weiterhin erfolgt die Versetzungsbewegung der Keim-Schraubenversetzungen insbesondere im Wesentlichen in radialer oder seitlicher (= lateraler) Richtung, d.h. im Wesentlichen in einer senkrecht zur Wachstumsrichtung des aufwachsenden SiC-Volumeneinkristalls orientierten Richtung. Die Wachstumsrichtung des aufwachsenden SiC-Volumeneinkristalls wird dagegen auch als axiale Richtung verstanden.

Unter einer Schraubenversetzung wird hier sowohl eine reine Schraubenversetzung als auch eine der Mischformen, die zumindest auch eine Komponente in m- oder a-Kristallrichtung haben, verstanden.

Es wurde erkannt, dass eine Hauptursache für eine erhöhte Schraubenversetzungsdichte im aufwachsenden SiC-Volumeneinkristall (und damit auch in den daraus später hergestellten scheibenförmigen SiC-Substraten) der zur Züchtung verwendete SiC-Keimkristall ist. So können sich im SiC-Keimkristall vorhandene Keim-Schraubenversetzungen während des Züchtungsvorgangs in Wachstumsrichtung in den wachsenden SiC-Volumeneinkristall fortpflanzen. Um dies weitestgehend zu vermeiden, wird der SiC-Keimkristall noch vor Züchtungsbeginn und vorzugsweise auch noch bei Raumtemperatur mit einer mechanischen Spannung beaufschlagt, um auf diese Weise die Anzahl der im SiC-Keimkristall ursprünglich vorhandenen Keim-Schraubenversetzungen bis zum Züchtungsbeginn zu reduzieren.

Durch Wechselwirkung der Keim-Schraubenversetzungen untereinander können die betroffenen Schraubenversetzungen nämlich miteinander rekombinieren und sich als Folge davon gegenseitig auslöschen. Diese vorteilhafte Rekombination tritt insbesondere dann auf, wenn sich Keim-Schraubenversetzungen nahe kommen, und es sich um Schraubenversetzungen mit unterschiedlicher Drehrichtung, d.h. mit unterschiedlichem Vorzeichen des jeweiligen Burgers-Vektors (+1c und -1c), handelt. Im SiC-Keimkristall liegt das Verhältnis der Anzahl von Schraubenversetzungen mit positivem Burgers-Vektor zu der Anzahl von Schraubenversetzungen mit negativem Burgers-Vektor üblicherweise bei nahezu 1, so dass prinzipiell zahlreiche Möglichkeiten zur vorteilhaften Rekombination von Keim-Schraubenversetzungen bestehen. Um die günstige Rekombination in Gang zu setzen, wird der SiC-Keimkristall mechanisch ver- oder gespannt. Letzteres bildet die Triebkraft dafür, dass die bestehenden Keim-Schraubenversetzungen sich in Bewegung setzen und ihre Position innerhalb des SiC-Keimkristalls um eine gewisse Wegstrecke verändern. Im Rahmen dieser Versetzungsbewegungen können sich lokal benachbarte Keim-Schraubenversetzungen mit unterschiedlicher Drehrichtung insbesondere soweit aneinander annähern, dass es zu einer Rekombination kommt. Dieser Effekt ist umso ausgeprägter, je höher die mechanische Spannung im jeweiligen Bereich ist. Je höher die mechanische Spannung ist, desto höher ist auch die Beweglichkeit der Keim-Schraubenversetzungen. Außerdem folgen die Keim-Schraubenversetzungen bei ihrer Versetzungsbewegung insbesondere einem Gradienten der mechanischen Spannung und bewegen sich bevorzugt entsprechend der Richtung dieses Gradienten.

Die miteinander rekombinierenden Schraubenversetzungen löschen sich also vorzugsweise noch im SiC-Keimkristall aus und können sich folglich auch nicht in der Kristallstruktur des aufwachsenden SiC-Volumeneinkristalls fortsetzen. Damit reduziert sich die Schraubenversetzungsdichte im aufwachsenden SiC-Volumeneinkristall. Die noch verbleibenden Schraubenversetzungen sind insbesondere inhomogen verteilt angeordnet. In lateraler oder radialer Richtung gibt es insbesondere Bereiche, in denen eine höhere lokale Schraubenversetzungsdichte vorliegt als in anderen Bereichen. Vorzugsweise lassen sich bezogen auf eine Querschnittsfläche senkrecht zur Wachstumsrichtung des aufwachsenden SiC-Volumeneinkristalls gezielt weite Bereiche (oder auch nur ein weiter Bereich) mit relativ niedriger lokaler Schraubenversetzungsdichte erzeugen, wohingegen nur vergleichsweise kleine Bereiche (oder auch nur ein vergleichsweise kleiner Bereich) mit demgegenüber höherer lokaler Schraubenversetzungsdichte vorhanden ist. Zur Weiterverarbeitung sind vorzugsweise die weiten Bereiche (oder auch nur der weite Bereich) mit relativ niedriger lokaler Schraubenversetzungsdichte bestimmt. Bei Bedarf kann die mechanische Spannung auch nur in einen Rekombinations-Teilbereich (z.B. nur in den Zentralbereich oder nur in den Randbereich) des SiC-Keimkristalls eingebracht werden, um dort die vorteilhafte Rekombination von Keim-Schraubenversetzungen besonders zu begünstigen.

Mit dem erfindungsgemäßen Verfahren lässt sich Schraubenversetzungsdichte im aufwachsenden SiC-Volumeneinkristall (und damit auch in den daraus später hergestellten scheibenförmigen SiC-Substraten) vorzugsweise in bestimmten Bereichen, beispielsweise im Randbereich oder im Zentralbereich, reduzieren. Der SiC-Volumeneinkristall ist dort vorzugsweise nahezu, im Idealfall sogar komplett frei von Schraubenversetzungen. Verglichen mit bisher bekannten Verfahren sind die Bereiche mit vergleichsweise niedriger lokaler Schraubenversetzungsdichte größer und haben außerdem bevorzugt auch eine niedrigere lokale Schraubenversetzungsdichte. Es ist von Vorteil, den Großteil der Schraubenversetzungen auf einen deutlich kleineren Bereich zu konzentrieren. Aufgrund dieser günstigen inhomogen verteilten Schraubenversetzungsdichte mit erhöhter lokaler Schraubenversetzungsdichte in einem nur kleinen Ausschussbereich eignen sich aus einem solchen SiC-Volumeneinkristall gewonnene SiC-Substrate sehr gut für eine wirtschaftliche Herstellung qualitativ hochwertiger elektronischer Bauelemente. Die erzielbare Ausbeute ist hoch.

Insgesamt können mit dem erfindungsgemäßen Züchtungsverfahren SiC-Volumeneinkristalle hergestellt werden, aus denen sich hochqualitative SiC-Substrate gewinnen lassen. Solche SiC-Substrate mit in weiten Bereichen hoher Genauigkeit in ihrer SiC-Kristallstruktur bieten nahezu ideale Bedingungen für die im Rahmen der Bauelementeherstellung durchzuführenden Folgeprozessschritte. Erfindungsgemäß hergestellte SiC-Volumeneinkristalle lassen sich also sehr effizient weiterverwenden, insbesondere zur Herstellung von Halbleiter- und/oder Hochfrequenzbauelementen.

Mit dem erfindungsgemäßen Verfahren kann ein einziger SiC-Volumeneinkristall, aber auch eine größere Anzahl, beispielsweise zwei, drei, vier, fünf oder auch vorzugsweise bis zu zehn SiC-Volumeneinkristalle, hergestellt werden. Günstig ist ein Verfahren, bei dem zwei insbesondere in Richtung der Mittenlängsachse über- oder hintereinander angeordnete SiC-Volumeneinkristalle gezüchtet werden, die in Richtung der Mittenlängsachse betrachtet auf beiden Seiten des SiC-Vorratsbereichs aufwachsen.

Vorteilhafte Ausgestaltungen des erfindungsgemäßen Verfahrens ergeben sich aus den Merkmalen der von Anspruch 1 abhängigen Ansprüche.

Günstig ist eine Ausgestaltung, bei der die Versetzungsbewegungen der Keim-Schraubenversetzungen thermisch aktiviert werden, indem der SiC-Keimkristall erhitzt wird. Der SiC-Keimkristall wird insbesondere auf eine Temperatur von etwas, vorzugsweise von bis zu etwa 200°C, unterhalb der Züchtungstemperatur gebracht, insbesondere für eine Aktivierungszeitdauer von 20 min bis 2000 min, bevorzugt von etwa 200 min. Ab einer Temperatur von etwa 200°C unterhalb der während der eigentlichen Züchtung an der Wachstumsoberfläche des SiC-Keimkristalls herrschenden Züchtungstemperatur, also insbesondere ab einer Temperatur von etwa 2000°C bis 2200°C, kommt es vorzugsweise zur Initiierung der Versetzungsbewegungen in maßgeblichem Umfang. Letztere sind somit insbesondere mechanisch induziert und thermisch aktiviert. Die Erhitzung des SiC-Keimkristalls zur thermischen Aktivierung der Versetzungsbewegungen kann bevorzugt im Zusammenhang mit der Aufheizphase vor dem Züchtungsbeginn erfolgen. Alternativ kann dies aber ebenso im Rahmen einer gesondert von der eigentlichen Züchtung durchgeführten, also mit der Züchtung insbesondere nicht in näherem zeitlichen Zusammenhang stehenden, thermischen Behandlung des SiC-Keimkristalls erfolgen.

Gemäß einer weiteren günstigen Ausgestaltung wird die mechanische Spannung rotationssymmetrisch in den SiC-Keimkristall eingebracht. Eine rotationssymmetrische Spannungsbeaufschlagung lässt sich besonders einfach umsetzen und ist zugleich sehr wirksam.

Gemäß einer weiteren günstigen Ausgestaltung wird der SiC-Keimkristall zur Einbringung der mechanischen Spannung verbogen, insbesondere mit einer maximalen Verbiegestrecke zwischen 0,1 mm und 5 mm, vorzugsweise von 1 mm. Die größte Verbiegung mit der maximalen Verbiegestrecke erfolgt dabei insbesondere im axialen Zentrum des SiC-Keimkristalls, vorzugsweise in Richtung einer Mittenlängsachse des später auf den SiC-Keimkristall aufwachsenden SiC-Volumeneinkristalls. Die sich dann im SiC-Keimkristall einstellende mechanische Spannung ist eine besonders wirksame Triebkraft für die Versetzungsbewegungen. Die mechanische Spannung ist insbesondere mit der Verbiegung korreliert.

Gemäß einer weiteren günstigen Ausgestaltung wird der SiC-Keimkristall zur Einbringung der mechanischen Spannung insbesondere im Züchtungstiegel mittels mindestens eines Stempels verbogen. Die Verbiegung des SiC-Keimkristalls kann dabei insbesondere direkt oder indirekt bewirkt werden. So kann der SiC-Keimkristall durch unmittelbare Krafteinwirkung des mindestens einen Stempels auf ihn selbst verbogen werden. Ebenso kann dies aber auch durch indirekte Krafteinwirkung, beispielsweise auf ein Keimhaltersystem mit einem Keimhalter und dem darauf platzierten SiC-Keimkristall, erfolgen. Der Stempel hat vorzugsweise eine Zylinderform mit einem Stempel-Durchmesser von insbesondere zwischen 2 mm und 10 mm. Weiterhin kann eine Stempelkontaktfläche des Stempels, mit der der Stempel (direkt oder indirekt) gegen den SiC-Keimkristall drückt, verschieden ausgestaltet sein, beispielsweise eben, abgerundet oder spitz zulaufend. Der Stempel besteht aus einem Stempelmaterial insbesondere in Form von Graphit, von anderen Kohlenstoffmaterialien oder von einem Refraktärmetall, wie z.B. Tantal. Mittels eines solchen Stempels lässt sich der SiC-Keimkristall sehr gut in einen weitgehend beliebig ge- oder verspannten Zustand versetzen, um so eine gezielte Rekombination von Keim-Schraubenversetzungen anzustoßen.

Gemäß einer weiteren günstigen Ausgestaltung wird der mindestens eine Stempel zentral platziert und wirkt auf ein Zentrum des SiC-Keimkristalls ein. Weiterhin gibt es eine andere günstige Ausgestaltung, bei der mehrere Stempel auf den SiC-Keimkristall einwirken, wobei insbesondere zumindest ein Teil dieser Stempel, vorzugsweise äquidistant, längs einer fiktiven Kreislinie um ein Zentrum des SiC-Keimkristalls platziert werden. Jede dieser Ausgestaltungen eignet sich sehr gut zur Einbringung von mechanischer Spannung in den SiC-Keimkristall.

Gemäß einer weiteren günstigen Ausgestaltung wird der SiC-Keimkristall zur Einbringung der mechanischen Spannung fest mit einer unebenen Kontaktfläche eines geformten Keimhalters verbunden. An sich ist der SiC-Keimkristall insbesondere scheibenförmig und hat vorzugsweise mindestens eine ebene Hauptfläche. Die unebene Kontaktfläche des geformten Keimhalters dient insbesondere zur Anlage des SiC-Keimkristalls und führt im anliegenden und/oder miteinander verbundenen Zustand zu einer Verbiegung des SiC-Keimkristalls und somit zu der gewünschten mechanischen Verspannung des SiC-Keimkristalls. Zur Verbindung wird der SiC-Keimkristall vorzugsweise an die Kontaktfläche angeklebt. Die Kontaktfläche ist beispielsweise konvex oder konkav gekrümmt. Sie kann aber auch eine weitgehend beliebige unebene Form aufweisen. Insbesondere kann sie auch nur in einem ersten Teilbereich uneben und in einem zweiten Teilbereich eben sein. Dadurch lässt sich die mechanische Spannung sehr gezielt und insbesondere auch auf einen bestimmten Teilbereich beschränkt in den SiC-Keimkristall einbringen. Die Rekombination von Keim-Schraubenversetzungen findet dann bevorzugt auch nur in dem Teilbereich (z.B. nur im Zentralbereich oder nur im Randbereich) statt, innerhalb dessen der SiC-Keimkristall mit einer mechanischen Spannung belegt ist.

Gemäß einer weiteren günstigen Ausgestaltung wird der SiC-Keimkristall vor dem Einbringen der mechanischen Spannung auf das Vorhandensein von Keim-Schraubenversetzungen an seiner Wachstumsoberfläche untersucht, beispielsweise mittels eines röntgentopographischen Untersuchungsverfahrens. Damit besteht die Möglichkeit, den SiC-Keimkristall gezielt dort mit einer mechanischen Spannung zu beaufschlagen, wo im Rahmen der vorangegangenen Untersuchung besonders viele Keim-Schraubenversetzungen festgestellt worden sind. In einem solchen besonders stark mit Keim-Schraubenversetzungen versehenen Teilbereich lässt sich auf diese Weise die dort außergewöhnlich (oder überdurchschnittlich) hohe Zahl an Keim-Schraubenversetzungen gezielt und erheblich reduzieren.

Zur Lösung der das SiC-Substrat betreffenden Aufgabe wird ein SiC-Substrat entsprechend den Merkmalen des Anspruchs 9 angegeben. Bei dem erfindungsgemäßen einkristallinen SiC-Substrat handelt es sich um ein solches, das eine Gesamt-Hauptoberfläche hat, wobei die Gesamt-Hauptoberfläche eine durch höchstens 20 % der Gesamt-Hauptoberfläche gebildete Kumulations-Teilfläche aufweist, welche Kumulations-Teilfläche mindestens 80 % aller an der Gesamt-Hauptoberfläche vorhandenen Substrat-Schraubenversetzungen aufweist.

Die durch höchstens 20 % der Gesamt-Hauptoberfläche gebildete Kumulations-Teilfläche kann insbesondere zusammenhängend sein und beispielsweise den Zentralbereich oder den Randbereich enthalten. Sie kann aber auch nicht zusammenhängend ausgebildet sein. Innerhalb dieser Kumulations-Teilfläche konzentrieren sich die meisten der Substrat-Schraubenversetzungen. Die Substrat-Schraubenversetzungen sind also insbesondere inhomogen über die Gesamt-Hauptoberfläche verteilt. Dies hat den Vorteil, dass bekannt ist, wo eine besondere Häufung der Substrat-Schraubenversetzungen auftritt, und wo im Umkehrschluss vorteilhafterweise nur wenige Substrat-Schraubenversetzungen vorhanden sind. Bei der Weiterverwendung des SiC-Substrats z.B. zur Herstellung von elektronischen Bauelementen kann dies berücksichtigt werden, beispielsweise indem der Teilbereich des SiC-Substrats mit der Kumulations-Teilfläche als Ausschuss betrachtet und nicht zur Bauelemente-Herstellung verwendet wird.

Für eine hochwertige Bauelemente-Herstellung mit hoher Ausbeute ist im Rahmen der epitaktischen Beschichtung eines SiC-Substrats vor allem eine niedrige Anzahl von Substrat-Schraubenversetzungen im epitaktisch beschichteten Teilbereich des SiC-Substrats von großer Bedeutung, da sich die Substrat-Schraubenversetzungen in die epitaktische Schicht fortpflanzen können. So kann z.B. eine zu hohe Anzahl an Substrat-Schraubenversetzungen zur Reduzierung der lokalen Ladungsträgerlebensdauer und zur Reduzierung der Durchbruchspannung in daraus hergestellten elektronischen Bauelementen führen. Aufgrund der verglichen mit bekannten Lösungen deutlich stärkeren Konzentration der im SiC-Substrat vorhandenen Substrat-Schraubenversetzungen auf einer außerdem kleineren Teilfläche hat das erfindungsgemäße SiC-Substrat einen größeren weiteren Teilbereich, der praktisch und im Idealfall sogar vollständig frei von Substrat-Schraubenversetzungen ist und sich somit bestens für alle denkbaren Fälle zur Weiterverwendung eignet. Der vermeintliche Nachteil einer inhomogenen Verteilung der Substrat-Schraubenversetzungen stellt sich bei dem erfindungsgemäßen SiC-Substrat insofern als Vorteil heraus. Das SiC-Substrat eignet sich insbesondere sehr gut für die Herstellung hochwertiger elektronischer Bauelemente mit einer hohen Ausbeute.

Das erfindungsgemäße SiC-Substrat, das insbesondere aus einem sublimationsgezüchteten SiC-Volumeneinkristall hergestellt ist, erfüllt die industriellen Anforderungen bezüglich eines Einsatzes zur Herstellung von Halbleiterbauelementen. Eine senkrecht zur Gesamt-Hauptoberfläche gemessene Substratdicke eines solchen SiC-Substrats liegt insbesondere im Bereich zwischen etwa 100 µm und etwa 1000 µm und vorzugsweise im Bereich zwischen etwa 200 µm und etwa 500 µm, wobei die Substratdicke eine über die komplette Gesamt-Hauptoberfläche betrachtete globale Dickenschwankung von vorzugsweise höchstens 20 µm aufweist. Das SiC-Substrat hat eine gewisse mechanische Stabilität und ist insbesondere selbsttragend. Es hat bevorzugt eine im Wesentlichen runde Scheibenform, d.h. die Gesamt-Hauptoberfläche ist praktisch rund. Gegebenenfalls kann aufgrund mindestens einer am Umfangsrand vorgesehenen Kennzeichnungsmarkierung eine geringfügige Abweichung von der exakt kreisrunden Geometrie vorliegen. Diese Kennzeichnungsmarkierung kann ein Flat oder ein Notch sein. Das SiC-Substrat ist insbesondere dadurch aus einem sublimationsgezüchteten SiC-Volumeneinkristall, beispielsweise aus einem nach dem vorstehend beschriebenen erfindungsgemäßen Herstellungsverfahren gezüchteten SiC-Volumeneinkristall, hergestellt, dass es als Scheibe senkrecht zu einer Mittenlängsachse des SiC-Volumeneinkristalls abgeschnitten worden ist.

Ansonsten bieten das erfindungsgemäße SiC-Substrat und seine günstigen Varianten im Wesentlichen die gleichen Vorteile, die bereits im Zusammenhang mit dem erfindungsgemäßen Herstellungsverfahren und dessen günstigen Varianten beschrieben worden sind.

Weitere vorteilhafte Ausgestaltungen des erfindungsgemäßen SiC-Substrats ergeben sich aus den Merkmalen der von Anspruch 9 abhängigen Ansprüche.

Günstig ist eine Ausgestaltung, bei der die Kumulations-Teilfläche mindestens 85 %, insbesondere mindestens 90 %, aller an der Gesamt-Hauptoberfläche vorhandenen Substrat-Schraubenversetzungen aufweist. Damit ergibt sich eine noch größere günstige Konzentration der Substrat-Schraubenversetzungen mit der Folge einer noch besseren Eignung der restlichen Teilfläche(n) des SiC-Substrats für die Weiterverwendbarkeit, insbesondere für die Herstellung hochwertiger Bauelemente.

Gemäß einer weiteren günstigen Ausgestaltung hat die Kumulations-Teilfläche eine Größe von höchstens 15 % der Gesamt-Hauptoberfläche. Damit ergibt sich eine noch kleinere Kumulations-Teilfläche, innerhalb derer sich die meisten Substrat-Schraubenversetzungen befinden. Auch dies hat eine noch bessere Eignung der restlichen Teilfläche(n) des SiC-Substrats für die Weiterverwendbarkeit, insbesondere für die Herstellung hochwertiger Bauelemente, zur Folge.

Gemäß einer weiteren günstigen Ausgestaltung hat das SiC-Substrat eine Schraubenversetzungs-Gesamtdichte von höchstens 1000 /cm², insbesondere von höchstens 500 /cm². Die Schraubenversetzungs-Gesamtdichte kann dabei insbesondere dadurch ermittelt werden, dass die Anzahl aller an der gesamten Gesamt-Hauptoberfläche des SiC-Substrats vorhandenen und/oder erfassbaren Substrat-Schraubenversetzungen auf den Flächenwert dieser Gesamt-Hauptoberfläche bezogen wird. Alternativ kann die Schraubenversetzungs-Gesamtdichte insbesondere auch als arithmetischer Mittelwert von lokalen Schraubenversetzungs-Segmentdichten, ermittelt werden. Die lokalen Schraubenversetzungs-Segmentdichten gelten dabei jeweils für eines von mehreren Segmenten, in die die Gesamt-Hauptoberfläche fiktiv aufgeteilt wird. Die Schraubenversetzungs-Gesamtdichte kann insofern insbesondere auch als globale und/oder mittlere Schraubenversetzungs-Substratdichte bezeichnet werden. Die vorstehend für die für die Schraubenversetzungs-Gesamtdichte genannten Werte sind sehr niedrig, so dass sich das SiC-Substrat auch insofern sehr gut für einen Einsatz bei der Herstellung hochwertiger Bauelemente eignet.

Gemäß einer weiteren günstigen Ausgestaltung hat die Gesamt-Hauptoberfläche (und damit insbesondere auch das SiC-Substrat insgesamt) einen Substratdurchmesser von mindestens 150 mm, insbesondere von mindestens 200 mm. Bevorzugt liegt der Substratdurchmesser bei etwa 200 mm. Eine derzeit fertigungsbedingte Obergrenze des Substratdurchmessers liegt insbesondere bei 250 mm, wobei grundsätzlich aber auch noch größere Substratdurchmesser denkbar sind. Je größer der Substratdurchmesser ist, umso effizienter kann das einkristalline SiC-Substrat beispielsweise zur Herstellung von Halbleiter- und/oder Hochfrequenzbauelementen weiterverwendet werden. Dadurch sinken die Bauelemente-Herstellungskosten. Ein SiC-Substrat mit einem so großen Durchmesser kann mit Vorteil außerdem auch zur Herstellung von relativ großen Halbleiter- und/oder Hochfrequenzbauelementen, die z.B. eine Grundfläche von etwa 1 cm² haben, verwendet werden.

Gemäß einer weiteren günstigen Ausgestaltung hat das SiC-Substrat eine SiC-Kristallstruktur mit nur einem einzigen SiC-Polytyp, insbesondere mit einem der SiC-Polytypen 4H, 6H, 15R und 3C. Bevorzugt liegt eine hohe Modifikationsstabilität vor, die sich insbesondere durch die weitest gehende Abwesenheit von Polytypwechseln auszeichnet. Wenn das SiC-Substrat nur einen einzigen SiC-Polytyp aufweist, hat es vorteilhafterweise auch nur eine sehr geringe Defektdichte. Es resultiert eine qualitativ sehr hochwertiges SiC-Substrat. Besonders bevorzugt ist der Polytyp 4H.

Gemäß einer weiteren günstigen Ausgestaltung hat das SiC-Substrat eine Kristallstruktur mit einer bezogen auf die Flächennormale der Gesamt-Hauptoberfläche geringfügig verkippten Orientierung (= off-Orientierung), wobei ein Verkippungswinkel im Bereich zwischen 0° und 8°, vorzugsweise bei etwa 4°, liegt. Insbesondere entspricht die Flächennormale der Gesamt-Hauptoberfläche zumindest im Wesentlichen der Wachstumsrichtung des SiC-Volumeneinkristalls, aus dem das SiC-Substrat hergestellt ist. Insbesondere ist bei der off-Orientierung die Gesamt-Hauptoberfläche des SiC-Substrats gegenüber der (0001)-Ebene der Kristallstruktur um einen Winkel im Bereich zwischen 0° und 8° in Richtung der [-1-120]-Kristallrichtung verkippt.

Gemäß einer weiteren günstigen Ausgestaltung hat das SiC-Substrat einen spezifischen elektrischen Widerstand von 8 mΩcm bis 26 mΩcm, insbesondere von 10 mΩcm bis 24 mΩcm.

Gemäß einer weiteren günstigen Ausgestaltung hat das SiC-Substrat eine Verbiegung (engl.: bow) von kleiner als 25 µm, insbesondere von kleiner als 15 µm.

Gemäß einer weiteren günstigen Ausgestaltung hat das SiC-Substrat eine Verwölbung (engl.: warp) von kleiner als 40 µm, insbesondere von kleiner als 30 µm.

Weitere Merkmale, Vorteile und Einzelheiten der Erfindung ergeben sich aus der nachfolgenden Beschreibung von Ausführungsbeispielen anhand der Zeichnung. Es zeigt:
- Fig. 1: ein Ausführungsbeispiel einer Züchtungsanordnung zur Sublimationszüchtung eines SiC-Volumeneinkristalls,
- Fig. 2: ein Ausführungsbeispiel eines mittels der Züchtungsanordnung gemäß Fig. 1 auf einen SiC-Keimkristall aufgewachsenen und inhomogen verteilte Schraubenversetzungen aufweisenden SiC-Volumeneinkristalls in einer Längsschnittdarstellung in Wachstumsrichtung,
- Fig. 3: ein Ausführungsbeispiel eines im Rahmen der Züchtungsanordnung gemäß Fig. 1 verwendeten mittels eines Stempels verbiegbaren Keimhalters,
- Fig. 4 bis 6: Ausführungsbeispiele des im Rahmen des verbiegbaren Keimhalters gemäß Fig. 3 verwendeten Stempels,
- Fig. 7: der mittels eines einzigen Stempels verbiegbare Keimhalter gemäß Fig. 3 in einer schematischen Draufsicht,
- Fig. 8: ein weiteres Ausführungsbeispiel eines im Rahmen der Züchtungsanordnung gemäß Fig. 1 verwendeten mittels mehrerer Stempel verbiegbaren Keimhalters in einer schematischen Draufsicht,
- Fig. 9 und 10: Ausführungsbeispiele von im Rahmen der Züchtungsanordnung gemäß Fig. 1 verwendeten geformten Keimhaltern mit jeweils unebener Kontaktfläche zur Anlage eines SiC-Keimkristalls,
- Fig. 11: ein Ausführungsbeispiel eines SiC-Substrats in einer Draufsicht gewonnen aus einem SiC-Volumeneinkristall ähnlich zu dem in Fig. 2 gezeigten, und
- Fig. 12: ein Ausführungsbeispiel eines SiC-Substrats in einer Draufsicht gewonnen aus einem SiC-Volumeneinkristall mit inhomogen verteilten und in einem Zentralbereich konzentrierten Schraubenversetzungen.

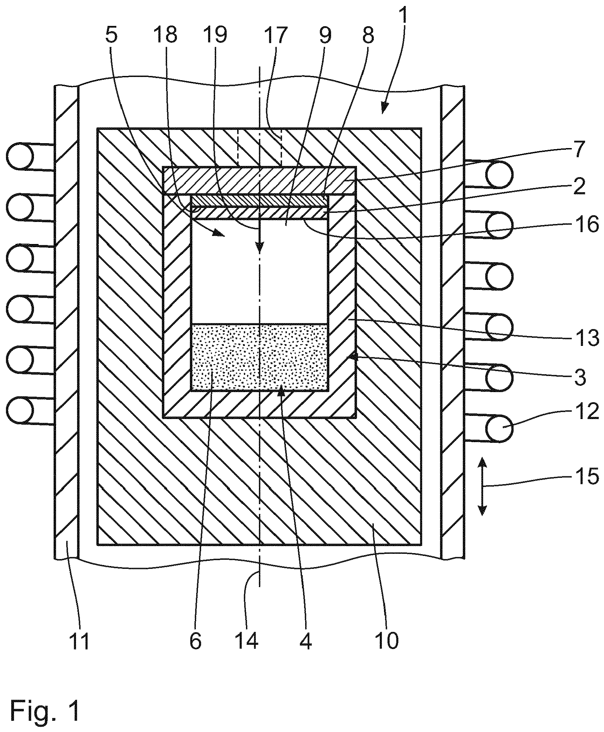

Einander entsprechende Teile sind in den Fig. 1 bis 12 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 ist ein Ausführungsbeispiel einer Züchtungsanordnung 1 zur Herstellung eines SiC-Volumeneinkristalls 2 mittels Sublimationszüchtung dargestellt. Die Züchtungsanordnung 1 enthält einen Züchtungstiegel 3, der einen SiC-Vorratsbereich 4 sowie einen Kristallwachstumsbereich 5 umfasst. In dem SiC-Vorratsbereich 4 befindet sich beispielsweise pulverförmiges SiC-Quellmaterial 6, das als vorgefertigtes Ausgangsmaterial vor Beginn des Züchtungsprozesses in den SiC-Vorratsbereich 4 des Züchtungstiegels 3 eingefüllt wird.

Im Bereich einer dem SiC-Vorratsbereich 4 gegenüberliegenden Tiegelstirnwand 7 des Züchtungstiegels 3 ist ein sich axial bis in den Kristallwachstumsbereich 5 erstreckender SiC-Keimkristall 8 angebracht. Die Art der Anbringung wird im Folgenden noch näher beschrieben. Der SiC-Keimkristall 8 ist insbesondere einkristallin. Die Tiegelstirnwand 7 ist beim gezeigten Ausführungsbeispiel als Tiegeldeckel des Züchtungstiegels 3 ausgebildet. Dies ist aber nicht zwingend. Auf dem SiC-Keimkristall 8 wächst der zu züchtende SiC-Volumeneinkristall 2 mittels Abscheidung aus einer sich im Kristallwachstumsbereich 5 ausbildenden SiC-Wachstumsgasphase 9 auf. Der aufwachsende SiC-Volumeneinkristall 2 und der SiC-Keimkristall 8 haben in etwa den gleichen Durchmesser. Wenn überhaupt, ergibt sich eine Abweichung von höchstens 10%, um die ein Keimdurchmesser des SiC-Keimkristalls 8 kleiner als ist ein Einkristalldurchmesser des SiC-Volumeneinkristalls 2. Allerdings kann zwischen der Innenseite einer Tiegelseitenwand 13 einerseits und dem aufwachsenden SiC-Volumeneinkristall 2 sowie dem SiC-Keimkristall 8 andererseits ein in Fig. 1 nicht gezeigter Spalt vorhanden sein.

Der Züchtungstiegel 3 inklusive des Tiegeldeckels 7 besteht bei dem Ausführungsbeispiel gemäß Fig. 1 aus einem elektrisch und thermisch leitfähigen Graphit-Tiegelmaterial mit einer Dichte von z.B. mindestens 1,75 g/cm³. Um ihn herum ist eine thermische Isolationsschicht 10 angeordnet. Letztere besteht z.B. aus einem schaumartigen Graphit-Isolationsmaterial, dessen Porosität insbesondere deutlich höher ist als die des Graphit-Tiegelmaterials.

Der thermisch isolierte Züchtungstiegel 3 ist innerhalb eines rohrförmigen Behälters 11 platziert, der beim Ausführungsbeispiel als Quarzglasrohr ausgeführt ist und einen Autoklaven oder Reaktor bildet. Zur Beheizung des Züchtungstiegels 3 ist um den Behälter 11 ist eine induktive Heizeinrichtung in Form einer Heizspule 12 angeordnet. Der Züchtungstiegel 3 wird mittels der Heizspule 12 auf die für die Züchtung erforderlichen Temperaturen erhitzt. Bei dem gezeigten Ausführungsbeispiel liegen diese Wachstumstemperaturen bei mindestens 2250°C. Die Heizspule 12 koppelt einen elektrischen Strom induktiv in die elektrisch leitfähige Tiegelseitenwand 13 des Züchtungstiegels 3 ein. Dieser elektrische Strom fließt im Wesentlichen als Kreisstrom in Umfangsrichtung innerhalb der kreis- und hohlzylindrischen Tiegelseitenwand 13 und heizt dabei den Züchtungstiegel 3 auf. Bei Bedarf kann die relative Position zwischen der Heizspule 12 und dem Züchtungstiegel 3 axial, d.h. in die Richtung einer Mittenlängsachse 14 des aufwachsenden SiC-Volumeneinkristalls 2, verändert werden, insbesondere um die Temperatur bzw. den Temperaturverlauf innerhalb des Züchtungstiegels 3 einzustellen und ggf. auch zu verändern. Die während des Züchtungsprozesses axial veränderbare Position der Heizspule 12 ist in Fig. 1 durch den Doppelpfeil 15 angedeutet. Insbesondere wird die Heizspule 12 an den Wachstumsfortschritt des aufwachsenden SiC-Volumeneinkristalls 2 angepasst verschoben. Die Verschiebung erfolgt vorzugsweise nach unten, also in Richtung des SiC-Quellmaterials 6, und bevorzugt um die gleiche Länge, um die der SiC-Volumeneinkristall 2 aufwächst, z.B. insgesamt um etwa 20 mm. Hierzu umfasst die Züchtungsanordnung 1 nicht näher gezeigte entsprechend ausgestaltete Kontroll-, Steuer- und Verstellmittel.

Die SiC-Wachstumsgasphase 9 im Kristallwachstumsbereich 5 wird durch das SiC-Quellmaterial 6 gespeist. Die SiC-Wachstumsgasphase 9 enthält zumindest Gasbestandteile in Form von Si, Si₂C und SiC₂ (= SiC-Gasspezies). Der Materialtransport vom SiC-Quellmaterial 6 zu einer Wachstumsgrenzfläche 16 am aufwachsenden SiC-Volumeneinkristall 2 erfolgt einerseits längs eines axialen Temperaturgradienten. Bei dem für die SiC-Kristallzüchtung verwendeten Sublimationsverfahren (= PVT-Verfahren) werden die Wachstumsbedingungen inklusive des Materialtransports über die im Züchtungstiegel 3 herrschenden Temperaturen eingestellt und geregelt. An der Wachstumsgrenzfläche 16 herrscht eine relativ hohe Wachstumstemperatur von mindestens 2250°C, insbesondere sogar von mindestens 2350°C oder 2400°C°. Außerdem wird an der Wachstumsgrenzfläche 16 insbesondere ein in Richtung der Mittenlängsachse 14 gemessener axialer Temperaturgradient von mindestens 5 K/cm, vorzugsweise von mindestens 15 K/cm, eingestellt. Die Temperatur innerhalb des Züchtungstiegels 3 nimmt zu dem aufwachsenden SiC-Volumeneinkristall 2 hin ab. Die höchste Temperatur liegt mit etwa 2450°C bis 2550°C im Bereich des SiC-Vorratsbereichs 4. Dieser Temperaturverlauf mit einer Temperaturdifferenz von insbesondere 100°C bis 150°C zwischen dem SiC-Vorratsbereich 4 und der der Wachstumsgrenzfläche 16 lässt sich über verschiedene Maßnahmen erreichen. So kann über eine nicht näher gezeigte Aufteilung der Heizspule 12 in zwei oder mehrere axiale Teilabschnitte eine axial variierende Beheizung vorgesehen werden. Weiterhin kann im unteren Abschnitt des Züchtungstiegels 3, z.B. durch eine entsprechende axiale Positionierung der Heizspule 12, eine stärkere Heizwirkung eingestellt werden als im oberen Abschnitt des Züchtungstiegels 3. Außerdem kann die Wärmedämmung an den beiden axialen Tiegelstirnwänden unterschiedlich ausgebildet sein. Wie in Fig. 1 schematisch angedeutet kann hierzu die thermische Isolationsschicht 10 an der unteren Tiegelstirnwand eine größere Dicke haben als an der oberen Tiegelstirnwand. Weiterhin ist es möglich, dass die thermische Isolationsschicht 10 benachbart zu der oberen Tiegelstirnwand 7, eine um die Mittenlängsachse 14 angeordnete zentrale Kühlöffnung 17 aufweist, durch die Wärme abgeführt wird. Diese zentrale Kühlöffnung 17 ist in Fig. 1 durch die gestrichelte Linien angedeutet.

Außerdem herrscht in dem Züchtungstiegel 3 während der eigentlichen Kristallzüchtung ein Züchtungsdruck von insbesondere 0,1 hPa (= mbar) bis 10 hPa (= mbar).

Der SiC-Volumeneinkristall 2 wächst auf eine Wachstumsoberfläche 18 des SiC-Keimkristalls 8 auf. Dieses Wachstum erfolgt in einer Wachstumsrichtung 19, die im in Fig. 1 gezeigten Ausführungsbeispiel von oben nach unten, also vom Tiegeldeckel 7 hin zu dem SiC-Vorratsbereich 4, orientiert ist. Die Wachstumsrichtung 19 verläuft parallel zu der zentralen Mittenlängsachse 14. Da der aufwachsende SiC-Volumeneinkristall 2 bei dem gezeigten Ausführungsbeispiel konzentrisch innerhalb der Züchtungsanordnung 1 angeordnet ist, kann die zentrale Mittenlängsachse 14 auch der Züchtungsanordnung 1 insgesamt zugeordnet werden.

Der aufwachsende SiC-Volumeneinkristall 2 hat eine SiC-Kristallstruktur vom 4H-Polytyp. Grundsätzlich ist aber auch ein anderer Polytyp (= eine andere Kristallmodifikation), wie z.B. 6H-SiC, 3C-SiC oder 15R-SiC, möglich. Vorteilhafterweise hat der SiC-Volumeneinkristall 2 nur einen einzigen SiC-Polytyp, welcher bei dem Ausführungsbeispiel besagtes 4H-SiC ist. Der SiC-Volumeneinkristall 2 wächst mit einer hohen Modifikationsstabilität auf und hat insofern im Wesentlichen nur einen einzigen Polytyp. Letzteres ist günstig im Hinblick auf eine sehr defektarme hohe Kristallqualität.

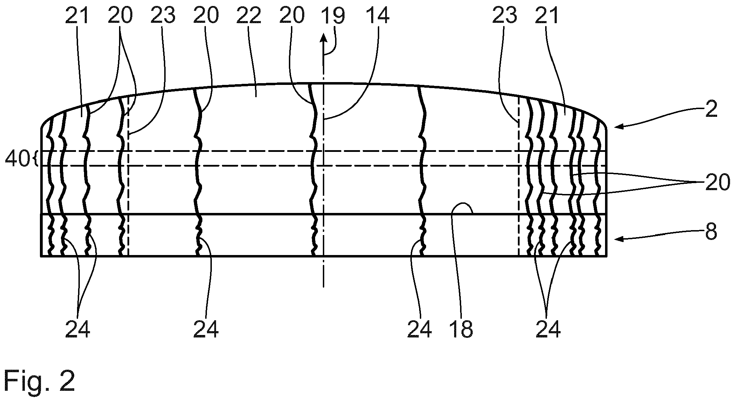

Das mittels der Züchtungsanordnung 1 durchgeführte Züchtungsverfahren zur Herstellung des SiC-Volumeneinkristalls 2 zeichnet sich auch in anderer Hinsicht durch eine erzielte hohe Kristallqualität aus. So hat der aufwachsende SiC-Volumeneinkristall 2 innerhalb einer beliebigen Querschnittsfläche senkrecht zur Wachstumsrichtung 19 eine inhomogene Verteilung von Volumeneinkristall-Schraubenversetzungen 20 (siehe Fig. 2). Diese inhomogene Verteilung hat vorzugsweise eine Zweiteilung in einen (ein- oder mehrteiligen) Kumulations-Teilbereich 21, in dem sich der größte Teil der Volumeneinkristall-Schraubenversetzungen 20 konzentriert, und in einen (ein- oder mehrteiligen) Nutzungs-Teilbereich 22, der verglichen mit dem Kumulations-Teilbereich 21 deutlich weniger Volumeneinkristall-Schraubenversetzungen 20 enthält bei zugleich größerer Fläche. Bei dem in Fig. 2 gezeigten Beispiel ist der Kumulations-Teilbereich 21 einteilig und durch den radialen Randbereich des SiC-Volumeneinkristalls 2 gebildet. Dementsprechend ist der Nutzungs-Teilbereich 22 ebenfalls einteilig und durch den um die zentrale Mittenlängsachse 14 herum angeordneten Zentralbereich des SiC-Volumeneinkristalls 2 gebildet. Die Grenze zwischen dem Kumulations-Teilbereich 21 und dem Nutzungs-Teilbereich 22 ist in Fig. 2 durch eine (fiktive) Grenzlinie 23 angedeutet. Der größere Nutzungs-Teilbereich 22 enthält nur sehr wenige Volumeneinkristall-Schraubenversetzungen 20 und ist deshalb sehr hochwertig.

Diese hohe Qualität des SiC-Volumeneinkristalls 2 ist auch durch den zugrundeliegenden SiC-Keimkristall 8 begründet, welcher eine ähnliche günstige inhomogene Verteilung seiner Keim-Schraubenversetzungen 24 hat wie der während der folgenden Züchtung darauf aufwachsende SiC-Volumeneinkristall 2. Insbesondere setzen sich nämlich die im SiC-Keimkristall 8 vorhandenen Keim-Schraubenversetzungen 24 in Wachstumsrichtung 19 in dem aufwachsenden SiC-Volumeneinkristall 2 fort, was in der Darstellung gemäß Fig. 2 verdeutlicht ist. Die Keim-Schraubenversetzungen 23 führen an der Wachstumsoberfläche 18 des SiC-Keimkristalls 8 zur Ausbildung der Volumeneinkristall-Schraubenversetzungen 20 im aufwachsenden SiC-Volumeneinkristall 2.

Insofern ist es günstig, wenn der SiC-Keimkristall 8 insbesondere spätestens zu dem Zeitpunkt, zu dem die eigentliche Züchtung des SiC-Volumeneinkristalls 2 startet, eine Verteilung seiner Keim-Schraubenversetzungen 24 und/oder eine auf seine der Wachstumsoberfläche 18 bezogene Keim-Schraubenversetzungs-Gesamtdichte hat, die zumindest in etwa in dieser Form in den SiC-Volumeneinkristall 2 vererbt werden soll und kann.

Um dies zu erreichen, wird der SiC-Keimkristall 8 vor seinem Einsatz zur Züchtung des SiC-Volumeneinkristalls 2 einer Behandlung unterzogen, die zu einer zumindest teilweisen Rekombination und gegenseitiger Auslöschung der in diesem Ausgangsstadium im SiC-Keimkristall 8 gegebenenfalls noch recht zahlreich vorhandenen Keim-Schraubenversetzungen 24 führt. Hierzu wird der SiC-Keimkristall 8 vorzugsweise noch bei Raumtemperatur mit einer mechanischen Spannung beaufschlagt und danach insbesondere erhitzt. Dies führt zu einer Versetzungsbewegung anfänglich bestehender Keim-Schraubenversetzungen 24. Im Rahmen dieser Versetzungsbewegung können sich Keim-Schraubenversetzungen 24 mit gegenläufigen Burgers-Vektoren soweit einander annähern, dass es zu einer Rekombination und gegenseitiger Auslöschung des betreffenden Paares der Keim-Schraubenversetzungen 24 kommt. Diese vorteilhafte gezielte Reduzierung der Keim-Schraubenversetzungen 24 ist somit mechanisch induziert (durch die in den SiC-Keimkristall 8 eingebrachte mechanische Spannung) und thermisch aktiviert (durch die danach durchgeführte thermische Behandlung). Bei der thermischen Behandlung, die die günstige Versetzungsbewegung in Gang setzt, wird der mechanisch verspannte SiC-Keimkristall 8 auf eine Temperatur von um bis zu 200°C unterhalb der später während der eigentlichen Züchtung am SiC-Keimkristall 8 herrschenden Züchtungstemperatur. Beispielsweise liegt die Behandlungstemperatur bei etwa 2100°C. Diese thermische Behandlung dauert vorzugsweise etwa 200 Minuten. Nach Abschluss dieser vorgeschalteten Behandlung liegt im SiC-Keimkristall 8 die beispielhaft in der Darstellung gemäß Fig. 2 angedeutete günstige inhomogene Verteilung der Keim-Schraubenversetzungen 24 mit nur noch sehr wenigen Keim-Schraubenversetzungen 24 im Zentralbereich vor.

Im Folgenden werden Beispiele zur Einbringung der vorteilhaften mechanischen Spannung in den Keimkristall 8 beschrieben.

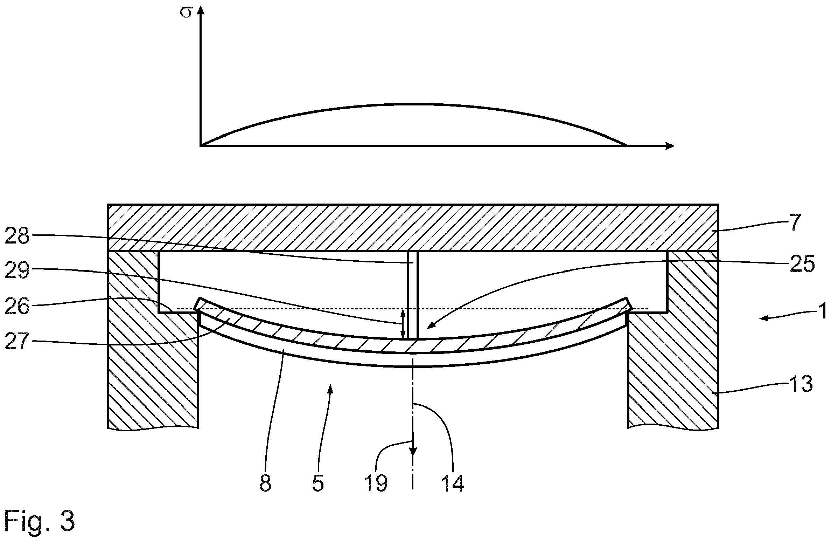

In Fig. 3 ist ein Ausführungsbeispiel eines im Rahmen der Züchtungsanordnung 1 verwendeten Keimhalters 25 gezeigt, welcher eine auf einem Wandvorsprung 26 der Tiegelseitenwand 13 aufliegende Halteplatte 27 und einen in Richtung der Mittenlängsachse 14 verstellbaren Stempel 28 aufweist. Der SiC-Keimkristall 8 ist an der dem Kristallwachstumsbereich 5 zugewandten Vorderseite der Halteplatte 27 befestigt, insbesondere angeklebt. Der Stempel 28 steht an der davon abgewandten Rückseite der Halteplatte 27 mit derselben in Kontakt. Mittels einer Vorschub-Bewegung des Stempels 28 in Richtung des Kristallwachstumsbereichs 5 wird die Einheit aus Halteplatte 27 und angeklebtem SiC-Keimkristall 8 verbogen. Im Zentrum ist die Verbiegung am größten. Dort wird der SiC-Keimkristall 8 um eine Verbiegestrecke 29 von etwa 1 mm verbogen. Die Verbiegung des SiC-Keimkristalls 8 ist mit einer in ihn eingebrachten mechanischen Spannung σ korreliert. In Fig. 3 ist in einem mit dargestellten Diagramm schematisch der Verlauf dieser in den SiC-Keimkristall 8 eingebrachten mechanischen Spannung σ veranschaulicht. Auch deren Maximum befindet sich im Zentrum des SiC-Keimkristalls 8. Dort ist die Beweglichkeit der Keim-Schraubenversetzungen 24 am höchsten, da diese Beweglichkeit von der Stärke der am jeweiligen Ort gegebenen mechanischen Spannung abhängt. Bei der im Rahmen der Temperbehandlung erfolgenden Erhitzung werden sich also insbesondere die im Zentralbereich des SiC-Keimkristalls 8 vorhandenen Keim-Schraubenversetzungen 24 in Bewegung setzen und mit besonders hoher Wahrscheinlichkeit miteinander rekombinieren.

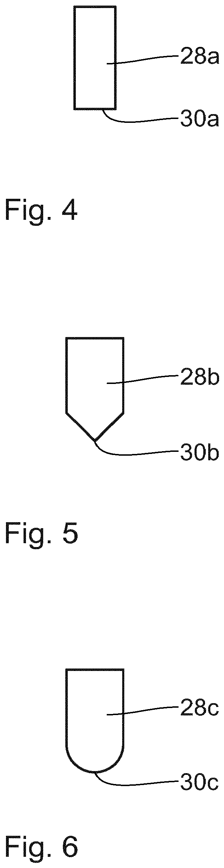

Der verstellbare Stempel 28 hat eine zylindrische Form. Seine an die Rückseite der Halteplatte 27 drückende Stempelspitze kann verschiedene Formen haben. In Fig. 4 bis 6 sind drei Ausführungsbeispiele gezeigt. Der in Fig. 4 gezeigte Stempel 28a hat eine ebene Stempelspitze 30a, der in Fig. 5 gezeigte Stempel 28b eine spitz zulaufende konische Stempelspitze 30b und der in Fig. 6 gezeigte Stempel 28c eine halbkugelförmig abgerundete Stempelspitze 30c.

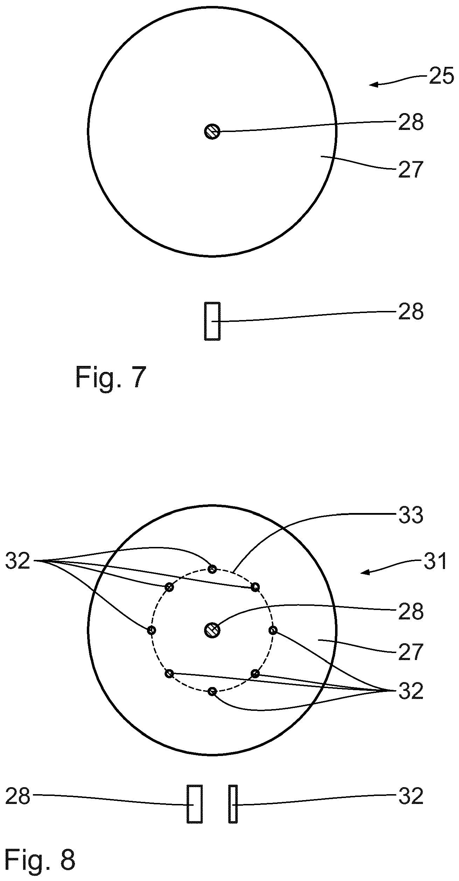

In Fig. 7 ist der mittels des einzigen Stempels 28 verbiegbare Keimhalter 25 gemäß Fig. 3 in einer schematischen Draufsicht auf die Rückseite der Halteplatte 27 in der Wachstumsrichtung 19 des zu züchtenden SiC-Volumeneinkristalls 2 gezeigt.

In Fig. 8 ist ein weiteres Ausführungsbeispiel eines im Rahmen der Züchtungsanordnung 1 verwendeten Keimhalters 31 in der gleichen Darstellung wie der Keimhalter 25 in Fig. 7 gezeigt. Der Keimhalter 31 ist im Wesentlichen genauso aufgebaut wie der Keimhalter 25. Auch er ist verbiegbar und gestattet somit die Beaufschlagung des SiC-Keimkristalls 8 mit einer mechanischen Spannung. Im Unterschied zum Keimhalter 25 hat der Keimhalter 31 aber neben dem zentral angeordneten Stempel 28 weitere Stempel 32, die konzentrisch um den Stempel 28 äquidistant längs einer Kreislinie 33 platziert sind. Die Stempel 32 sind ebenfalls zylindrisch und in Richtung der Mittenlängsachse 14 verstellbar. Ihr Stempeldurchmesser ist etwas kleiner als der des zentralen Stempels 28. Der Keimhalter 31 hat also zu seiner Verbiegung mehrere Stempel 28, 32, wodurch die Verbiegung des SiC-Keimkristalls 8 und damit auch die in den SiC-Keimkristall 8 einzubringende mechanische Spannung sehr gezielt eingestellt werden kann.

Mittels der Keimhalter 25 und 31 kann die Verbiegung des SiC-Keimkristalls 8 nur während der Vorbehandlung zur Reduzierung der im SiC-Keimkristall vorhandenen Keim-Schraubenversetzungen 24 eingestellt werden. Nach Abschluss der Vorbehandlung können die Stempel 28, 32 zurückgefahren werden und der Keimhalter 25 oder 31 inklusive des daran befestigten SiC-Keimkristalls 8 in den ungebogenen Zustand zurückgeführt werden, in dem dann danach die eigentliche Züchtung des SiC-Volumeneinkristalls 2 durchgeführt wird.

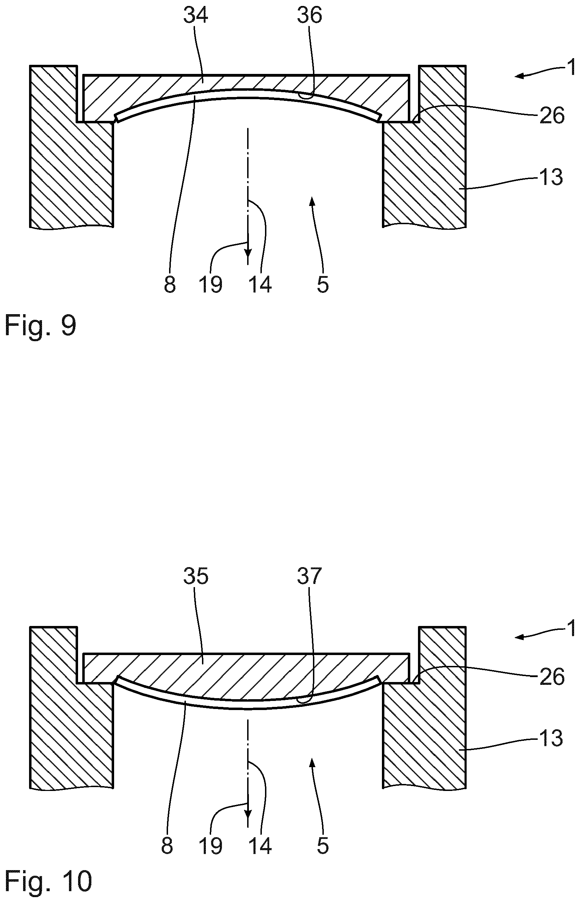

Demgegenüber gibt es weitere in Fig. 9 und 10 gezeigte Ausführungsbeispiele von im Rahmen der Züchtungsanordnung 1 verwendeten geformten Keimhaltern 34 bzw. 35, die jeweils eine unebene Kontaktfläche 36 bzw. 37 zur Anlage des SiC-Keimkristalls 8 haben und ebenfalls auf dem Wandvorsprung 26 der Tiegelseitenwand 13 aufliegen. Im Unterschied zu den Keimhaltern 25 und 31 sind die Keimhalter 34 und 35 nicht verstell- oder verbiegbar. Bei ihnen erfährt der an die jeweilige Kontaktfläche 36 bzw. 37 angeklebte SiC-Keimkristall 8 eine dauerhafte Verbiegung, wobei aber auch bei diesen Ausführungsbeispielen die für die Reduzierung der Keim-Schraubenversetzungen 24 maßgebliche mechanische Spannung entsprechend der unebenen Form der jeweiligen Kontaktfläche 36 bzw. 37 in den SiC-Keimkristall 8 eingebracht wird. Beim Keimhalter 34 ist die Kontaktfläche 36 konkav gekrümmt. Dementsprechend wird der daran angeklebte SiC-Keimkristall 8 nach hinten, also weg von dem Kristallwachstumsbereich 5 gebogen. Beim Keimhalter 35 ist die Kontaktfläche 37 konvex gekrümmt, so dass der daran angeklebte SiC-Keimkristall 8 ähnlich wie bei den Keimhaltern 34 und 35 nach vorne in der Richtung des Kristallwachstumsbereichs 5 gebogen wird. Grundsätzlich lassen sich auch beliebige andere Formen für unebene Kontaktflächen realisieren, deren genaue Form an das im jeweiligen Einzelfall in den SiC-Keimkristall 8 einzubringende mechanische Spannungsprofil angepasst werden kann.

Bei Bedarf kann der SiC-Keimkristall 8 zunächst auf das Vorhandensein von Keim-Schraubenversetzungen 24 untersucht werden. Diese Untersuchung erfolgt z.B. röntgentopographisch. Ein Teilbereich, der sich bei dieser Untersuchung als besonders mit Keim-Schraubenversetzungen 24 belastet herausgestellt hat, kann dann gezielt mit einer mechanischen Spannung beaufschlagt werden, um besonders dort die außergewöhnlich (oder überdurchschnittlich) hohe Zahl an Keim-Schraubenversetzungen 24 zu reduzieren.

Insgesamt ermöglicht die Züchtungsanordnung 1 in Verbindung mit den beschriebenen verschiedenen Varianten zur Reduzierung der im SiC-Keimkristall 8 vorhandenen Keim-Schraubenversetzungen 24 die Züchtung eines hochqualitativen SiC-Volumeneinkristalls 2, der nur wenige Volumeneinkristall-Schraubenversetzungen 20 hat, wobei letztere inhomogen verteilt sind und sich bevorzugt innerhalb des Kumulations-Teilbereichs 21 konzentrieren, welcher bei der Weiterverwendung des SiC-Volumeneinkristalls 2 zur Herstellung hochwertiger elektronischer Bauelemente vorteilhafterweise außen vor gelassen werden kann.

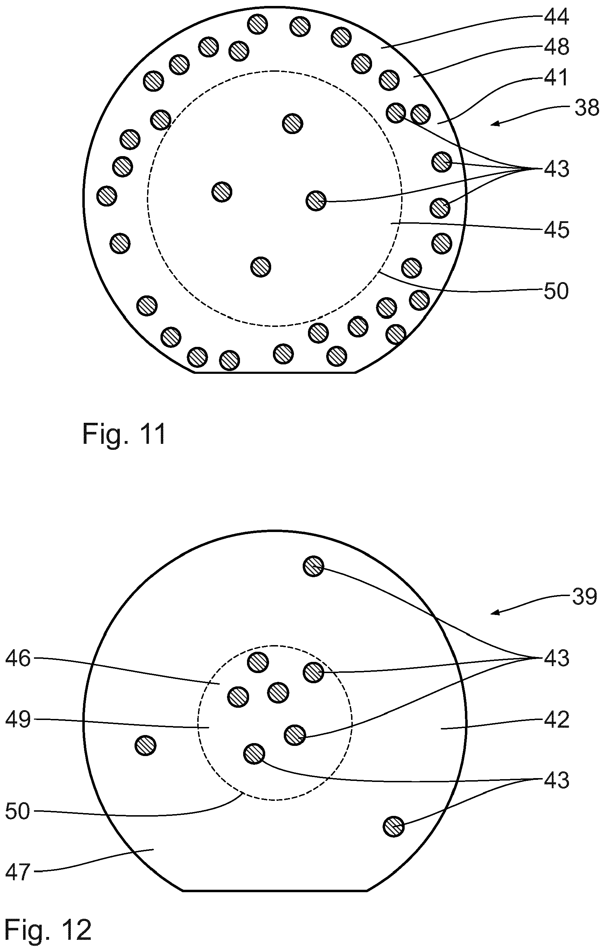

Aus diesen qualitativ hochwertigen SiC-Volumeneinkristallen 2 können dann ebenso hochwertige SiC-Substrate 38, 39 (siehe schematische Draufsicht-Darstellungen gemäß Fig. 11 und 12) hergestellt werden. Diese scheibenförmigen SiC-Substrate 38, 39 werden aus dem betreffenden SiC-Volumeneinkristall 2 dadurch gewonnen, dass sie axial sukzessive als Scheiben senkrecht zur Wachstumsrichtung 19 bzw. zur Mittenlängsachse 14 abgeschnitten bzw. abgesägt werden. Die Lage einer solchen ein SiC-Substrat bildenden Scheibe 40 innerhalb des SiC-Volumeneinkristalls 2 ist in der Darstellung gemäß Fig. 2 durch ein gestricheltes Rechteck beispielhaft angedeutet. Ein derartiges SiC-Substrat 38 oder 39 ist groß und dünn. In einer möglichen Ausführungsform hat seine Gesamt-Hauptoberfläche 41 bzw. 42 einen Substratdurchmesser von mindestens 150 mm, beispielsweise von 200 mm, wohingegen eine Substratdicke bei etwa 500 µm liegt. Das SiC-Substrat 38 oder 39 hat ebenso wie der SiC-Volumeneinkristall 2, aus dem es hergestellt ist, eine niedrige Schraubenversetzungs-Gesamtdichte von vorzugsweise höchstens 1000 cm⁻² und eine inhomogene Verteilung der verbliebenen Volumeneinkristall-Schraubenversetzungen 20, welche im Zusammenhang mit den Substraten 38, 39 auch als Substrat-Schraubenversetzungen 43 verstanden und bezeichnet werden können. Beides verbessert die Eignung des SiC-Substrats 38 oder 39 für einen Einsatz in der Bauelementeherstellung. Die Schraubenversetzungs-Gesamtdichte bezieht sich bei dem SiC-Volumeneinkristall 2 auf eine komplette Querschnittsfläche des SiC-Volumeneinkristalls 2 senkrecht zur Mittenlängsachse 14 oder zur Wachstumsrichtung 19 und bei dem SiC-Substrat 38 oder 39 auf die komplette Gesamt-Hauptoberfläche 41 bzw. 42. Die inhomogene Schraubenversetzungsverteilung geht aus den Abbildungen gemäß Fig. 11 und 12 hervor, in denen jeweils die Si-Seite des betreffenden SiC-Substrats 38 bzw. 39 gezeigt ist.

Bei dem SiC-Substrat 38 gemäß Fig. 11 sind die Substrat-Schraubenversetzungen 43 in einem durch den axialen Randbereich gebildeten Kumulations-Teilbereich 44 konzentriert, wohingegen sich in einem durch den Zentralbereich gebildeten Nutzungs-Teilbereich 45 deutlich weniger Substrat-Schraubenversetzungen 43 befinden. Letzterer eignet sich dementsprechend besonders gut für die Verwendung zur Herstellung hochwertiger Bauelemente. Insofern liegt eine ähnliche Schraubenversetzungsverteilung vor wie bei dem in Fig. 2 schematisch gezeigten Volumeneinkristall 2 und, wie sie durch Verwendung eines SiC-Keimkristalls 8 erreicht werden kann, der vor der eigentlichen Züchtung einer Vorbehandlung mit einer Verbiegung entsprechend der Darstellung gemäß Fig. 3, 9 oder 10 sowie mit einer thermischen Vorbehandlung unterzogen worden ist.

Bei dem SiC-Substrat 39 gemäß Fig. 12 sind die Verhältnisse gerade umgekehrt. Bei ihm sind die Substrat-Schraubenversetzungen 43 in einem durch den Zentralbereich gebildeten Kumulations-Teilbereich 46 konzentriert, wohingegen sich in einem durch den axialen Randbereich gebildeten Nutzungs-Teilbereich 47 deutlich weniger Substrat-Schraubenversetzungen 43 befinden. Letzterer eignet sich dementsprechend wiederum besonders gut für die Verwendung zur Herstellung hochwertiger Bauelemente.

Bei den SiC-Substraten 38, 39 ist der jeweilige Nutzungs-Teilbereich 45 bzw. 47 deutlich größer als der jeweilige Kumulations-Teilbereich 44 bzw. 46. Der jeweilige Kumulations-Teilbereich 44 oder 46 hat eine zugehörige Kumulations-Teilfläche 48 bzw. 49, welche Teil der betreffenden Gesamt-Hauptoberfläche 41 bzw. 42 ist und höchstens 20% derselben ausmacht. Dennoch befinden sich innerhalb dieser Kumulations-Teilfläche 48 oder 49 jeweils mindestens 80 % aller an der zugehörigen Gesamt-Hauptoberfläche 41 bzw. 42 vorhandenen Substrat-Schraubenversetzungen 43. Die Grenze zwischen dem kleineren Kumulations-Teilbereich 44 oder 46 und dem größeren zur Weiterverwendung bestimmten Nutzungs-Teilbereich 45 bzw. 47 ist in Fig. 11 und 12 jeweils durch eine gestrichelte (fiktive) Grenzlinie 50 angedeutet.

## Patentansprüche

1. Verfahren zur Herstellung mindestens eines SiC-Volumeneinkristalls (2) mittels einer Sublimationszüchtung, wobei
a) vor Züchtungsbeginn
a1) in einem Kristallwachstumsbereich (5) eines Züchtungstiegels (3) ein SiC-Keimkristall (8) mit einer Wachstumsoberfläche (18) angeordnet wird und
a2) in einen SiC-Vorratsbereich (4) des Züchtungstiegels (3) SiC-Quellmaterial (6) eingebracht wird, und
b) während der Züchtung bei einer Züchtungstemperatur von bis zu 2400°C und einem Züchtungsdruck zwischen 0,1 mbar und 100 mbar mittels Sublimation des SiC-Quellmaterials (6) und mittels Transport der sublimierten gasförmigen Komponenten in den Kristallwachstumsbereich (5) dort eine SiC-Wachstumsgasphase (9) erzeugt wird, in der mittels Abscheidung aus der SiC-Wachstumsgasphase (9) auf dem SiC-Keimkristall (8) ein SiC-Volumeneinkristall (2) aufwächst,
**dadurch gekennzeichnet, dass**
c) in den SiC-Keimkristall (8) vor Züchtungsbeginn bei Raumtemperatur eine mechanische Spannung eingebracht wird, um im SiC-Keimkristall (8) vorhandene Keim-Schraubenversetzungen (24) unter dem Einfluss der mechanischen Spannung zu einer Versetzungsbewegung zu veranlassen, so dass Keim-Schraubenversetzungen (24), die sich im Zusammenhang mit ihrer jeweiligen Versetzungsbewegung einander annähern, miteinander rekombinieren und sich gegenseitig auslöschen.

2. Verfahren nach Anspruch 1, **dadurch gekennzeichnet, dass** die Versetzungsbewegungen der Keim-Schraubenversetzungen (24) thermisch aktiviert werden, indem der SiC-Keimkristall (8) erhitzt wird.

3. Verfahren nach einem der Ansprüche 1 und 2, **dadurch gekennzeichnet, dass** die mechanische Spannung rotationssymmetrisch in den SiC-Keimkristall (8) eingebracht wird.

4. Verfahren nach einem der vorhergehenden Ansprüche, **dadurch gekennzeichnet, dass** der SiC-Keimkristall (8) zur Einbringung der mechanischen Spannung verbogen wird, insbesondere mit einer maximalen Verbiegestrecke zwischen 0,1 mm und 5 mm.

5. Verfahren nach einem der vorhergehenden Ansprüche, **dadurch gekennzeichnet, dass** der SiC-Keimkristall (8) zur Einbringung der mechanischen Spannung mittels mindestens eines Stempels (28; 28a; 28b; 28c; 32) verbogen wird.

6. Verfahren nach Anspruch 5, **dadurch gekennzeichnet, dass** der mindestens eine Stempel (28) zentral platziert wird und auf ein Zentrum des SiC-Keimkristalls (8) einwirkt.

7. Verfahren nach Anspruch 5 oder 6, **dadurch gekennzeichnet, dass** mehrere Stempel (28, 32) auf den SiC-Keimkristall (8) einwirken, wobei insbesondere zumindest ein Teil dieser Stempel (32), vorzugsweise äquidistant, längs einer fiktiven Kreislinie (33) um ein Zentrum des SiC-Keimkristalls (8) platziert werden.

8. Verfahren nach einem der vorhergehenden Ansprüche, **dadurch gekennzeichnet, dass** der SiC-Keimkristall (8) zur Einbringung der mechanischen Spannung fest mit einer unebenen Kontaktfläche (36; 37) eines geformten Keimhalters (34; 35) verbunden wird.

9. Einkristallines SiC-Substrat (38; 39) mit einer Gesamt-Hauptoberfläche (41; 42), wobei die Gesamt-Hauptoberfläche (41; 42) eine durch höchstens 20 % der Gesamt-Hauptoberfläche (41; 42) gebildete Kumulations-Teilfläche (48; 49) aufweist, welche Kumulations-Teilfläche (48; 49) mindestens 80 % aller an der Gesamt-Hauptoberfläche (41; 42) vorhandenen Substrat-Schraubenversetzungen (43) aufweist.

10. SiC-Substrat nach Anspruch 9, **dadurch gekennzeichnet, dass** die Kumulations-Teilfläche (48; 49) mindestens 85 %, insbesondere mindestens 90 %, aller an der Gesamt-Hauptoberfläche (41; 42) vorhandenen Substrat-Schraubenversetzungen (43) aufweist.

11. SiC-Substrat nach Anspruch 9 oder 10, **dadurch gekennzeichnet, dass** die Kumulations-Teilfläche (48; 49) eine Größe von höchstens 15 % der Gesamt-Hauptoberfläche (41; 42) hat.

12. SiC-Substrat nach einem der Ansprüche 9 bis 11, **dadurch gekennzeichnet, dass** das SiC-Substrat (38; 39) eine Schraubenversetzungs-Gesamtdichte von höchstens 1000 /cm², insbesondere von höchstens 500 /cm² hat.

13. SiC-Substrat nach einem der Ansprüche 9 bis 12, **dadurch gekennzeichnet, dass** die Gesamt-Hauptoberfläche (41; 42) einen Substratdurchmesser von mindestens 150 mm, insbesondere von mindestens 200 mm, hat.

14. SiC-Substrat nach einem der Ansprüche 10 bis 13, **dadurch gekennzeichnet, dass** das SiC-Substrat (38; 39) eine SiC-Kristallstruktur mit nur einem einzigen SiC-Polytyp hat, insbesondere mit einem der SiC-Polytypen 4H, 6H, 15R und 3C.

15. SiC-Substrat nach einem der Ansprüche 10 bis 14, **dadurch gekennzeichnet, dass** das SiC-Substrat (38; 39) einen spezifischen elektrischen Widerstand von 8 mΩcm bis 26 mΩcm, insbesondere von 10 mΩcm bis 24 mΩcm, hat.
